# EUROPEAN PATENT SPECIFICATION

(11) **EP 2 293 433 B1**
(45) Date of publication and mention of the grant of the patent: **02.11.2011**
(21) Application number: 09169181.6
(22) Date of filing: 01.09.2009
(51) Int. Cl.: H03F 1/02, H03F 1/56

(54) **Envelope tracking RF power amplifier unit and method for power amplification of an RF signal**
Hochfrequenzleistungsverstärker mit Hüllkurvennachführung und Verfahren zur Leistungsverstärkung eines Hochfrequenzsignals
Unité d'amplificateur de puissance RF de suivi d'enveloppes et procédé d'amplification de puissance d'un signal RF

(43) Date of publication of application: 09.03.2011
(73) Proprietor: Alcatel Lucent, 75007 Paris (FR)
(72) Inventor: Machinal, Robin, 70197 Stuttgart (DE); Wiegner, Dirk, 71409 Schwaikheim (DE); Luz, Gerhard, 74321 Bietigheim-Bissingen (DE)
(74) Representative: Schmidt, Werner Karl

(56) References cited:
- US-A1- 2004 108 895
- US-B2- 6 753 735
- US-B2- 7 149 496
- US-B2- 7 493 094

## Description

### Field of the Invention

The present invention relates to an envelope tracking RF power amplifier unit and to a method for power amplification of an RF input signal. The present invention further relates to a base station, and to a communication network, the base station and the communication network both comprising an envelope tracking RF power amplifier unit.

### Background

This section introduces aspects that may be helpful in facilitating a better understanding of the invention. Accordingly, the statements of this section are to be read in this light and are not to be understood as admissions about what is in the prior art or what is not in the prior art.

The envelope tracking concept combines an RF power amplifier with an envelope tracking modulator and is adapted to carry out amplification by envelope tracking of an RF input signal. The envelope tracking concept is a very promising approach in order to improve power amplifier efficiency. To achieve good performance of the RF power amplifier (e.g. efficiency) the envelope tracking modulator has to be located very close to the drain feed of the RF power amplifier (typically a Field-Effect-Transistor (FET)). Further, in case of conventional multi-stage RF power amplifiers using the envelope tracking concept, the modulated supply voltage is usually only fed to the final amplifier stage in order to improve the efficiency of the final stage. This is e.g. due to the fact that when providing the modulated voltage to different RF power transistor stages, it is difficult to guarantee that the delay between the modulated supply voltage and the RF signal is in phase for both the final stage as well as for a preceding stage, e.g. the driver stage, when using a single envelope tracking modulator for the multi-stage RF power amplifier.

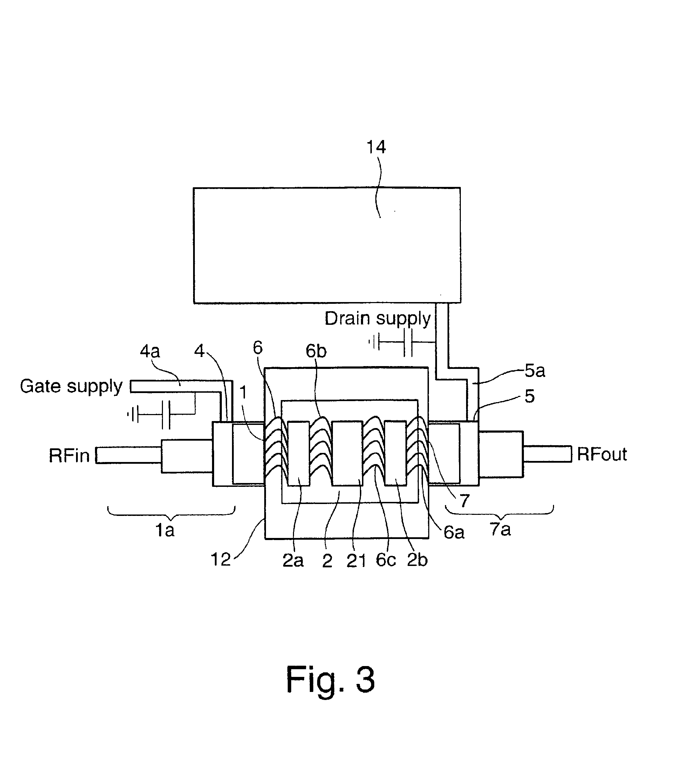

In the accompanying drawings, **Fig. 3** schematically shows a functional block diagram of an existing solution which combines an internally matched single-stage RF power transistor unit **2** in a housing **12** with a separately packaged envelope tracking modulator circuit module **14,** i.e. two integrated circuit modules 12 and 14 are packaged in separate housings and are connected by means of a drain supply line **5a** used as a supply voltage line for feeding a modulated drain supply voltage, i.e. the signal from the envelope tracking modulator circuit 14, to a drain supply voltage terminal **5** of an output matching network **7a** of the internally matched RF power transistor unit 2. Further, an RF input signal **RF in** is coupled to an input terminal **1** of the internally matched RF power transistor circuit 2 through an RF signal input line **1a** and from there via input signal bonding wires **6** to an internal pre-matching means 2a (input matching network).

The conventional RF amplifier 2 further has a gate supply line **4a** for receiving an amplifier control signal "Gate supply" (DC voltage) at a control terminal **4** of the RF signal input line 1a. ln the RF amplifier 2, the RF input signal "RF in" is fed from the internal pre-matching means 2a to an integrated power transistor chip **21** (power cell) via further bonding wires **6b.**

The amplified RF signal is then fed from the power transistor chip 21 via bonding wires **6c** to an output pre-matching network **2b,** essentially providing a pre-matching of the output impedance of the internally matched RF power transistor unit 2. From an output terminal **7** of the internally matched RF power transistor unit 2, the amplified output signal **"RF out"** is then fed via further bonding wires **6a** to the RF output line 7a for outputting an amplified RF signal **"RF out".**

The RF power amplifier implemented in the way described above may involve the following problems: The internally matched RF power transistor unit 2, in particular its power transistor chip 21, is packaged in a housing, and this transistor package housing adds parasitics, i.e. capacitances and inductances, which can disadvantageously affect RF power amplifier bandwidth, envelope tracking system bandwidth and therefore the overall performance of the envelope tracking power amplifier.

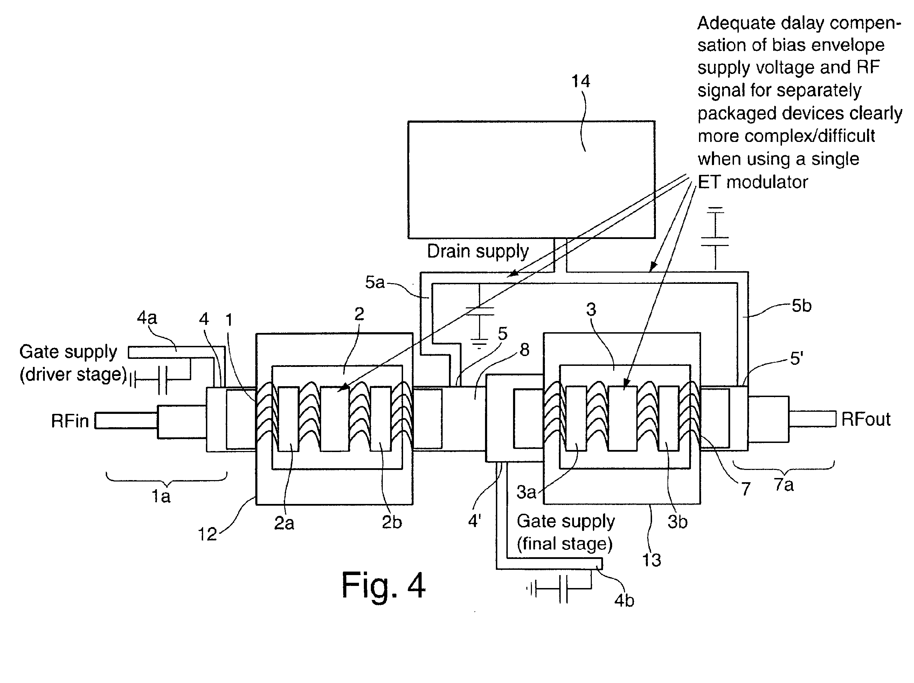

**Fig. 4** schematically shows a conventional two-stage RF power amplifier for amplification by envelope tracking of an RF input signal. The RF power amplifier of the present example is implemented in a first stage (driver stage) 2, and a final (output) stage 3. It will be understood that the block diagram shown in Fig. 4 is only an example of a two-stage RF power amplifier and that the RF power amplifier circuit may also comprise more than two transistor stages, or even two or more power transistor elements in parallel.

Like the one-stage envelope tracking RF power amplifier shown in Fig. 3, the envelope tracking RF power amplifier shown in Fig. 4 comprises a separate envelope tracking modulator circuit module 14 packaged in its own housing and connected to the supply voltage terminals 5, 5' of both internally matched RF power transistor stages 2 and 3, respectively, through a branched drain supply line 5a, 5b. Internally, both the internally matched RF power transistor driver stage 2 and the final stage 3 may be implemented similarly to the single stage 2 according to Fig. 3, each stage being provided with its own housing 12, **13.** Both, the internally matched RF power transistor driver stage 2 and the internally matched RF power transistor final stage 3 are interconnected by an interstage matching strip line **8.**

The internally matched RF power transistor driver stage 2 receives at its input terminal 1 the RF input signal "RF in" through an RF signal input strip line 1a, and the final RF power amplifier stage 3 outputs from its output terminal 7 the amplified output signal via an output signal strip line 7a. Further, separate first and second amplifier control signals "Gate Supply" are respectively supplied, via separate amplifier control signal input lines 4a and 4b, to respective control signal terminals 4, 4' located at the RF input line 1a and the inter-stage matching strip line 8, respectively.

The RF power amplifier schematically shown in Fig. 4 using a single envelope tracking modulator circuit module 14 may cause the following problems: Positioning of separate components, namely the envelope tracking modulator circuit module 14 and the two RF power amplifier circuit modules 12 and 13 to each other is much more complicated than in the conventional single-stage RF power amplifier system shown in Fig. 3. In particular, it is difficult to achieve good delay compensation of the envelope tracking bias voltage "Drain supply" and the RF power amplifier signal when supplying separately packaged driver stage 2 and final stage 3 of the internally matched RF power transistor with a single separate envelope tracking modulator circuit module 14. Moreover, also in this case, the transistor package housings add parasitics, i.e. capacitances and inductances, which can disadvantageously affect RF power amplifier bandwidth, envelope tracking system bandwidth and therefore the overall performance of the envelope tracking power amplifier unit. Other art is disclosed in US7493094, US 7149496, US 6753735, and US 2004/0108895.

### Summary

It is therefore an object of the present invention to provide an envelope tracking RF power amplifier unit, a base station comprising at least one such envelope tracking RF power amplifier unit, a communication network comprising at least one RF power amplifier unit, as well as a method for power amplification of an RF input signal which may achieve good overall performance, in particular with respect to efficiency and linearity.

According to a first aspect of the present invention, an envelope tracking RF power amplifier unit is provided, comprising: an RF power transistor unit for amplification of an RF input signal, and an envelope tracking modulator for feeding a supply voltage to the RF power transistor unit, wherein the RF power transistor unit, preferably also the envelope tracking modulator, is unpackaged, and wherein the envelope tracking modulator and the RF power transistor unit are arranged on a common circuit board (pallet), in particular on an common RF line card.

The basic idea is thus to combine a (typically unpackaged) integrated envelope tracking modulator (possibly implemented as a MMIC, as a chip or directly as a modulator circuit on the circuit board (components of the circuit being arranged directly on the circuit board)) with an unpackaged RF power transistor unit, comprising e.g. a single-stage RF power transistor circuit chip or even one or more unpacked multi-stage RF power transistor circuit chip or chips, on a common circuit line card (also referred to as a pallet). According to this basic idea of the invention, the envelope tracking modulator circuit can be combined with the RF power transistor circuit chip(s), closely connected together and possibly packaged in a specific package as a combined envelope tracking RF power amplifier unit for performing highly efficient amplification by envelope tracking. One benefit of this approach is that parasitics of the RF power amplifier circuit package of the approach described above are dispensed with, typically achieving an improved envelope tracking performance. Additionally, an improved positioning of the modulator and the RF power transistor elements as well as an overall size reduction can be achieved.

Additionally, in an unpackaged multi-stage RF power transistor circuit, the driver stage and the final RF transistor stage, either being integrated on one and the same chip or on separate integrated chips, may be located very close side by side. In particular, the final RF power amplifier circuit chip as well as the driver chip can be supplied by one and the same modulated supply voltage through one (unbranched) supply voltage line from the same envelope tracking modulator circuit without causing a harmful phase shift between the supply voltage signals being provided from the envelope tracking modulator to the driver stage and the final stage, respectively, since the RF path distances on the circuit board are almost negligible in this case.

Moreover, it will be understood that the RF amplifier unit of the present invention comprising the envelope tracking modulator circuit (e.g. a chip) and the RF power transistor unit can be packaged as one common envelope tracking RF power amplifier pallet. In such an amplifier pallet, the envelope tracking modulator supplying the modulated drain supply voltage can be located very close to the drain feed of the RF amplifier. Thus, the overall solution, comprising the ET modulator and the RF power cells together with the input and output matching networks, being packaged as one common ET RF amplifier pallet, can be more easily designed into an RF amplifier line-up for different mobile radio applications.

In one embodiment, the unpackaged RF power transistor unit is implemented as a one-stage integrated power transistor chip which comprises a power transistor amplifier element, typically a field effect transistor or a bipolar transistor. In the case of using a FET, the Gate and Drain terminal of the power transistor are typically connected to an RF input line and an RF output line, respectively, the Source terminal being typically connected to ground in the present kind of applications. The power transistor amplifier element may be implemented in metal oxide semiconductor (MOS) technology, or as a High Electron Mobility transistor (HEMT) using, for instance, gallium nitride (GaN) as a semiconductor material. Alternatively, the power transistor amplifier element may be implemented as a high-voltage hetero-junction bipolar transistor (HVHBT), in the latter case using e.g. gallium arsenide (GaAs) as a semiconductor material.

In an alternative embodiment, the unpackaged RF power transistor unit has at least two transistor stages including a driver transistor stage and a final transistor stage, each of said transistor stages including a power transistor amplifier element, the drain terminals thereof preferably forming a common supply voltage terminal for the supply voltage, the gate terminals thereof possibly forming a common amplifier control terminal for an amplifier control voltage. In such a multi-stage RF power amplifier, a single supply voltage line may be provided to a common supply voltage terminal of the RF power transistor unit, i.e. the supply voltage line may only branch very close to the respective transistor stages. In particular, a single, unbranched supply voltage line may be connected to a common supply voltage terminal of a circuit chip, the branches to the Drain terminals being implemented only on the chip and thus close to the transistor amplifier elements. As the branches of the supply voltage line on the chip can be made very short, the path length of the branches being selected such that a desired delay of the provisioning of the supply voltage to the driver stage and to the final stage can be attained. As a (short) propagation time is needed for the RF signal to propagate from the driver stage to the final stage, the provisioning of the supply voltage to the final stage has to be delayed by the same amount, thus generating a very small, desired delay difference between the Drain supply voltages being provided to the Drains of the different power transistor stages.

Further advantageously, at least two transistor stages are implemented as one integrated power transistor circuit chip. In this case, both amplifier stages are typically implemented as a common monolithic microwave integrated circuit, MMIC. Alternatively, the at least two amplifier stages can be respectively implemented as a separate, unpackaged integrated power transistor circuit chip (e.g. as a MMIC) and can thus be located very close side by side.

In a further embodiment, the common supply voltage terminal is connected to the envelope tracking modulator through a common supply voltage line. The common supply voltage line may only branch on the transistor circuit chip, such that the delay difference of the supply voltage signal which is provided to the different amplifier stages can be made very short, as the RF path differences between the respective Drain terminals can be made extremely small.

In one embodiment, the RF power amplifier unit further comprises: an RF signal input line for providing the RF input signal to an input terminal of the RF power transistor unit, and an RF signal output line for receiving from an output terminal of said RF power transistor unit an amplified RF output signal. The RF input and output lines are used for providing the input and output signals to the RF power transistor unit, possibly also providing impedance matching, see below.

The RF signal output line may comprise a supply voltage terminal of a supply voltage line connecting the RF power transistor unit, resp., the output line, to the envelope tracking modulator. This is typically the case when a single-stage power amplifier is used. Usually, the Drain terminal of the RF power amplifier is connected to the ET modulator via a quarter-wave section and a shunt capacitor. When a dual or multi-stage RF power amplifier is used, a common supply voltage terminal may be provided directly at the RF power transistor unit, as described above. The ET modulator comprises an input terminal for an envelope signal of the RF signal. The envelope signal may be provided by a digital processing unit arranged e.g. in the baseband part of a base station in which the RF power amplifier unit is implemented, or may alternatively be derived directly from the RF signal, e.g. by branching part of the RF signal from the RF signal path to an envelope detector from which the envelope signal may be provided to the input terminal of the ET modulator.

In a further embodiment, the RF signal input line comprises an amplifier bias terminal of an amplifier bias line for providing an amplifier bias voltage (Gate supply) to the RF power transistor unit. The bias terminal is typically provided at the RF input line when a single-stage RF power amplifier is used. For dual or multi-stage power amplifiers, a common amplifier control terminal may be provided directly at the RF power amplifier for common connection of the two (or more) Gate terminals of the respective transistor stages. Alternatively, two separate bias terminals may be used for independently controlling the Gate terminals of the respective transistor stages.

In another embodiment, the RF line card is implemented as an RF strip line card on which the RF signal input line and the RF signal output line are respectively arranged as RF strip lines, being connected to the RF signal input terminal and the RF signal output terminal of the RF power transistor unit, preferably via respective bonding wires. It will be understood that also the supply voltage line and the amplifier control line may be devised as strip lines on the RF line card.

In one improvement, the RF signal input line and the RF signal output line are respectively implemented as a RF input signal impedance matching strip line and as a RF output signal impedance matching strip line for respectively transforming an input impedance and an output impedance of the RF power transistor unit to the RF input signal impedance and the RF output signal impedance of the RF power amplifier unit, the latter being preferably 50 Ω. Thus, the integrated ET and RF transistor unit may be provided with a defined input and output impedance, e.g. of 50 Ω, by an appropriate impedance transformation of the (comparatively small) input and output impedance of the power transistor unit.

A further aspect of the invention is implemented in a base station comprising at least one RF amplifier unit as described above. The combined ET and RF amplifier module may be used in a transmitter of the base station, in particular as an RF line card which may be inserted into a transmitting device devised for this purpose. The device may, for example, be an active antenna element being connected to a baseband section of the base station via a cable connection.

A further aspect of the invention is implemented in a communication network comprising at least one RF amplifier unit as described above. The amplifier unit may typically be part of a base station of the communication network. It will be understood, however, that the RF amplifier module as described herein may also be implemented in a user equipment, for example in a mobile terminal or in another (not necessarily mobile) wireless device being part of the communication network.

Another aspect of the invention is provided in a method for power amplification of an RF input signal, comprising: feeding a supply voltage of a preferably unpacked envelope tracking modulator to an unpackaged RF power transistor unit, the RF power transistor unit and the envelope tracking modulator being arranged on a common circuit board, in particular on a common RF line card, and amplifying the RF input signal in the unpackaged RF power transistor unit. Using an unpackaged RF power transistor unit allows for reduction of parasitics which may otherwise cause a degradation of the overall envelope tracking performance.

In one variant, the unpackaged RF power transistor unit comprises at least two amplifier stages including a driver transistor stage and a final transistor stage, each of said transistor stages including a power transistor amplifier element, the output terminals thereof forming a common supply voltage terminal, the method further comprising: feeding the supply voltage to the common supply voltage terminal. By using a common supply voltage terminal for the RF power transistor unit, the difference in the RF path distances of the respective output terminals of the transistor elements to the envelope modulator may be made as small as possible, thus allowing provisioning of the common supply voltage to the transistor stages with a minimal delay difference. It will be understood that alternatively or in addition, a common supply voltage terminal may also be provided for provisioning of the bias signal (Gate supply) to the different transistor stages.

### Brief Description of the Figures

In the following description a number of exemplary embodiments of an inventive envelope tracking RF amplifier unit will be described in detail with reference to the following figures, wherein:
- Fig. 1: schematically depicts a functional block diagram of a first exemplary embodiment of an envelope tracking RF power amplifier unit according to the present invention;
- Fig. 2: schematically shows a functional block diagram of a second and third exemplary embodiment of an envelope tracking RF power amplifier unit according to the present invention;
- Fig. 3: schematically shows a functional block diagram of a one-stage envelope tracking RF power amplifier as explained in the introductory part of this specification, and
- Fig. 4: schematically shows a functional block diagram of a second envelope tracking RF power amplifier having a first and a second amplifier stage as explained in the introductory part of this specification.

### Description of the Embodiments

The functions of the various elements shown in the Figures, including any functional blocks labeled as 'processors', may be provided through the use of dedicated hardware as well as hardware capable of executing software in association with appropriate software. When provided by a processor, the functions may be provided by a single dedicated processor, by a single shared processor, or by a plurality of individual processors, some of which may be shared. Moreover, explicit use of the term 'processor' or 'controller' should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non volatile storage. Other hardware, conventional and/or custom, may also be included. Similarly, any switches shown in the Figures are conceptual only. Their function may be carried out through the operation of program logic, through dedicated logic, through the interaction of program control and dedicated logic, or even manually, the particular technique being selectable by the implementer as more specifically understood from the context.

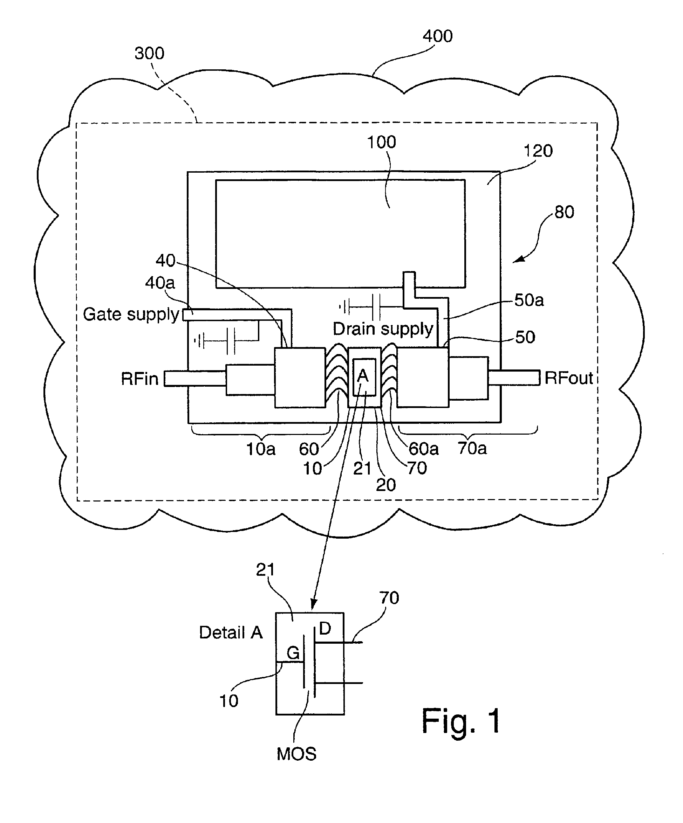

A first embodiment of the present RF power amplifier unit **80** as schematically shown in Fig. 1 comprises a single-stage RF power transistor unit **20** having an RF signal input terminal **10** and an RF signal output terminal **70.** This single-stage RF power transistor unit 20 comprises an integrated RF power transistor stage **21** schematically depicted in detail A of Fig. 1 as a MOS-FET power transistor chip. The gate terminal G thereof is coupled to the input terminal 10 the drain terminal D thereof is coupled to the output terminal 70 of the RF power transistor unit 20.

Further, the RF signal input terminal 10 is connected for receiving the input RF signal "RF in" through an RF signal input strip line **10a,** and the RF signal output terminal 70 is connected for receiving from said RF power amplifier transistor unit 20 an amplified RF output signal "RF out" based on said input RF signal "RF in" and for outputting the amplified RF output signal "RF out" through an RF signal output strip line **70a.** An amplifier control terminal **40** is formed at an intersection of an amplifier control signal input strip line **40a** for receiving an amplifier control signal "Gate supply" with the RF input strip line 10a, and a supply voltage terminal **50** is formed at an intersection of the RF output strip line 70a with a supply voltage strip line **50a** for receiving from an envelope tracking modulator circuit 100 a modulated supply voltage "Drain supply". As usual, the supply voltage strip line 50a also comprises a shunt capacitor for RF blocking.

The envelope tracking modulator circuit 100 is adapted for providing a supply voltage in dependence of an envelope of the RF input signal "RF in", the envelope signal being provided to the ET modulator 100 via a respective input terminal (not shown). The supply voltage "Drain supply" is modulated in response to the tracked envelope of the RF signal and is provided to the one-stage RF power transistor unit 20 through the supply voltage strip line 50a mentioned above.

The one-stage RF power transistor unit 20 is implemented as an unpackaged integrated RF power amplifier circuit chip and the envelope tracking modulator circuit is also implemented as an unpackaged integrated modulator circuit 100 and combined with and closely connected to the unpackaged integrated RF power transistor unit 20 on a common RF line card **120** which also includes the RF signal input strip line 10a, the RF output strip line 70a, the supply voltage strip line 50a, and the amplifier Gate bias control signal input strip line 40a. The unpackaged ET modulator 100 together with the unpackaged RF transistor unit 20 arranged on the circuit board 120 form an integrated envelope tracking power amplifier unit 80 which may be integrated in a common housing (not shown).

Further, as indicated in Fig. 1, the RF signal input strip line 10a and the RF signal output strip line 70a are respectively implemented as a RF input signal impedance matching strip line and a RF output signal impedance matching strip line and formed so as to match the RF input signal impedance and RF output signal impedance of the envelope tracking amplifier unit 80 to a desired value, e.g. to 50 Ω. Further, Fig. 1 clearly indicates that the RF signal input strip line 10a and the RF signal output strip line 70a are respectively connected to the RF signal input terminal 10 and RF signal output terminal 70 via respective bonding wires 60 and 60a.

Since according to the first embodiment shown in Fig. 1, the one-stage RF power transistor unit 20 is implemented as one unpackaged integrated RF power transistor circuit chip and the envelope tracking modulator circuit is implemented as one unpackaged integrated modulator circuit 100, both (circuit) chips 20 and 100 can be combined and closely connected on the common RF line card 120 together with the input impedance matching RF input signal strip line 10a, the output impedance matching RF output signal strip line 70a, the supply voltage strip line "Drain supply" 50a and the amplifier Gate bias control signal input strip line "Gate supply" 40a and housed as one common envelope tracking RF power amplifier pallet which can be easily designed into an RF amplifier line-up for different mobile radio applications.

The improvement of the overall envelope tracking amplifier performance and the easier implementation regarding RF design of envelope tracking into RF amplifier line-ups, achieves an improvement of overall performance, i.e. bandwidth, efficiency, and linearity of envelope tracking RF power amplifier systems having the above concept.

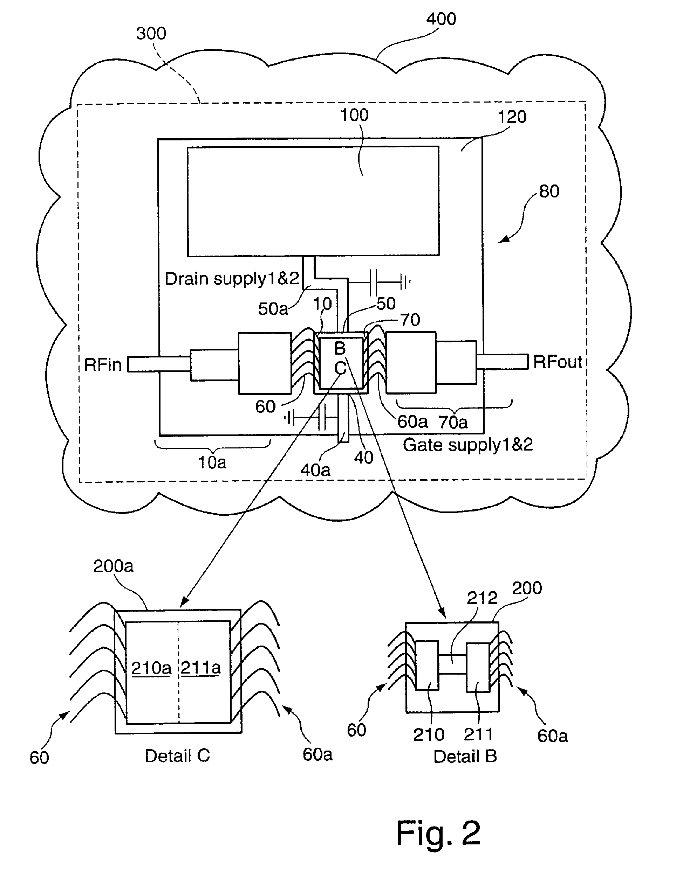

The enclosed Fig. 2 schematically illustrates in functional block diagrams a second and third embodiment of an envelope tracking RF power amplifier unit 80 according to the invention. As in the second and third embodiment of the present invention, the unpackaged integrated modulator circuit 100 is combined with and closely connected to an integrated RF power transistor circuit 200, 200a on the common RF line card 120 which also includes the input impedance matching RF signal input strip line 10a, the output impedance matching RF signal output strip line 70a, the supply voltage strip line 50a and the amplifier Gate bias signal input strip line 40a, these components of the second and third embodiment of the inventive envelope tracking RF power amplifier can also be packaged as one common envelope tracking RF power amplifier pallet as it is done for the first embodiment illustrated in Fig. 1.

Different from the first embodiment of the envelope tracking RF power amplifier 80 as illustrated in Fig. 1, in the second and third embodiment of the envelope tracking RF power amplifier 80 depicted in Fig. 2, the RF power transistor unit **200, 200a** has two amplifier stages, namely either according to the second embodiment schematically shown as detail B of Fig.2 forming an transistor driver stage 210 and a final transistor stage 211 respectively arranged as separate integrated transistor circuit chips connected via an inter-stage **212,** or, according to the third embodiment shown as detail C of Fig. 2, integrating the transistor driver stage 210a and the final transistor stage 211a together as one power amplifier circuit chip 200a. Each transistor stage, the transistor driver stage 210 or 210a and the final transistor stage 211 or 211a include a power transistor amplifier.

In the embodiments shown in Fig. 2, the gate terminals G of both transistor stages 210 and 211 or 210a and 211a are connected to a common transistor bias terminal 40, and the drain terminals D of both transistor stages 210 and 211 or 210a and 211a are connected to a common supply voltage terminal 50. However, it will be understood that when an individual bias control of the transistor stages 210 and 211 or 210a and 211a is required, two separate transistor bias terminals may be used instead of the common transistor bias terminal 40.

Since the transistor driver stage 210 or 210a and the final transistor stage 211 1 or 211a are either integrated on a common chip (in detail C) or (in detail B) are integrated as separate unpackaged chips which can be located very close side-by-side, the final transistor stage 211 or 211a as well as the transistor driver stage 210 or 210a can be supplied by a common modulated supply voltage from the same envelope tracking modulator circuit 100 without causing major delay problems between the envelope tracking modulator circuit 100 and the RF power transistor chip or chips for the driver and the final stage. This is due to the fact that the RF signal path distances on the chip or the respective chips of the RF power amplifier 200, 200a on the common line card 120 are very short. Additionally, e.g., the delay between the RF driver stage and RF final stage can be considered when designing the supply line branch of the final stage, further minimizing possible delay errors when feeding driver and common stage in parallel with the same modulator. Thus, the small delay of the RF path to the terminals of the different chips may be taken into account when dimensioning the feed lines of the RF amplifier 200, 200a.

It will be understood that the input terminal 10 and the output terminal 70 of the RF power transistor circuit chip or chips may also be electrically connected to the respective RF input and output strip lines 10a, 70a by using bonding wires 60, 60a, as it is done in the first embodiment illustrated in Fig. 1.

The skilled person will recognize from the above description of the embodiments of the inventive envelope tracking RF power amplifier unit 80 that the inventive concept is not restricted to a single-stage or two-stage RF power amplifier circuit, but that likewise a multi-stage RF power amplifier circuit having more than two amplifier stages may be realized with the same benefits as described above. Also feeding two or more transistors in parallel in the same transistor stage can be beneficial for the present purposes. Moreover, it may also be possible to provide more than one ET modulator for the different amplifier stage. Also, the line card may be adapted for amplification of more than one RF signal, in which case more than one RF amplifier and ET modulator may provided on a common line card.

Further, the inventive concept of an envelope tracking RF power amplifier unit 80 can be used to realize a base station **300** comprising at least one such RF power amplifier unit 80, either in the embodiment shown in Fig. 1 or in the embodiments shown in Fig. 2, forming an RF line card being integrated in a transmitting module, e.g. of an active antenna element (not shown). Likewise, the present invention encompasses a communication network **400** comprising at least one base station 300 including at least one RF power amplifier unit 80 being devised in the way described above. However, the RF power amplifier unit 80 may also be comprised in other devices of the communication network 400, for example in (possibly mobile) wireless terminals. It will be appreciated by those skilled in the art that- although not being explicitly described herein-that in the way described above, not only overall performance (efficiency, bandwidth, linearity) of single-band and single-standard power amplifiers, but also of multi-band as well as multi-standard power amplifiers and thus base stations may be increased.

Although in the text above, power transistor amplifier elements have been described as being implemented as MOS-FETs, one skilled in the art will appreciate that other implementations in field effect or bipolar technology are also possible. For instance, the power transistor amplifier elements may be implemented as High Electron Mobility transistors (HEMT) using, for instance, gallium nitride (GaN) as a semiconductor material. Alternatively, the power transistor amplifier elements may be implemented as a high-voltage hetero-junction bipolar transistors (HVHBT) using e.g. gallium arsenide (GaAs) as a semiconductor material. Amplifier elements of the HEMT and HVHBT type have been proven to be especially advantageous for Envelope tracking applications as described herein.

It should be appreciated by those skilled in the art that any block diagrams herein represent conceptual views of illustrative circuitry embodying the principles of the invention. Similarly, it will be appreciated that any flow charts, flow diagrams, state transition diagrams, pseudo code, and the like represent various processes which may be substantially represented in computer readable medium and so executed by a computer or processor, whether or not such computer or processor is explicitly shown.

Also, the description and drawings merely illustrate the principles of the invention. It will thus be appreciated that those skilled in the art will be able to devise various arrangements that, although not explicitly described or shown herein, embody the principles of the invention and are included within its scope. Furthermore, all examples recited herein are principally intended expressly to be only for pedagogical purposes to aid the reader in understanding the principles of the invention and the concepts contributed by the inventor(s) to furthering the art, and are to be construed as being without limitation to such specifically recited examples and conditions. Moreover, all statements herein reciting principles, aspects, and embodiments of the invention, as well as specific examples thereof, are intended to encompass equivalents thereof.

## Claims

1. An RF power amplifier unit (80) for envelope tracking, comprising:
an RF power transistor unit (20, 200, 200a) for amplification of an RF input signal (RF in), and
an envelope tracking modulator (100) for feeding a supply voltage (Drain supply) depending on an envelope of the RF input signal (RF in) to the RF power transistor unit (20, 200, 200a),
wherein the RF power transistor unit (20, 200, 200a) and also the envelope tracking modulator (100) are unpackaged, and
wherein the envelope tracking modulator (100) and the RF power transistor unit (20, 200, 200a) are arranged on a common circuit board, in particular on a common RF line card (120).

2. RF power amplifier unit according to claim 1, wherein the unpackaged RF power transistor unit (20) is implemented as a one-stage integrated power transistor chip (21) which comprises a power transistor amplifier element (MOS).

3. RF power amplifier unit according to claim 1 or 2, wherein the unpackaged RF power transistor unit (200; 200a) has at least two transistor stages (210, 211; 210a, 211a) including a driver transistor stage (210, 210a) and a final transistor stage (211, 211a), each of said transistor stages (210, 211; 210a, 211a) including a power transistor amplifier element (MOS), the output terminals (D) thereof preferably forming a common supply voltage terminal (50) for the supply voltage (Drain supply).

4. RF power amplifier unit according to claim 3, wherein the at least two transistor stages (210a, 211a) are implemented as one integrated power transistor circuit chip (210a, 211a).

5. RF power amplifier unit according to claim 3, wherein the at least two transistor stages are respectively implemented as a separate integrated power transistor circuit chip (210, 211).

6. RF power amplifier according to any one of claims 3 to 5, wherein the common supply voltage terminal (50) is connected to the envelope tracking modulator (100) through a common supply voltage line (50a).

7. RF power amplifier unit according to any one of the preceding claims, further comprising: an RF signal input line (10a) for providing the RF input signal (RF in) to an input terminal (10) of the RF power transistor unit (20, 200, 200a), and an RF signal output line (70a) for receiving from an output terminal (70) of said RF power transistor unit (20, 200, 200a) an amplified RF output signal (RF out).

8. RF power amplifier unit according to claim 7, wherein the RF signal output line (70a) comprises a supply voltage terminal (50) of a supply voltage line (50a) connecting the RF power transistor unit (20) to the envelope tracking modulator (100).

9. RF power amplifier unit according to claim 7 or 8, wherein the RF signal input line (10a) comprises an amplifier bias terminal (40) of an amplifier bias line (40a) for providing an amplifier bias voltage (Gate supply) to the RF power transistor unit (20).

10. RF power amplifier unit according to any one of claims 7 to 9, wherein the RF line card (120) is implemented as a RF strip line card on which the RF signal input line (10a) and the RF signal output line (70a) are respectively arranged as RF strip lines, being connected to the RF signal input terminal (10) and the RF signal output terminal (70) of the RF power transistor unit (20, 200, 200a) preferably via respective bonding wires (60, 60a).

11. RF power amplifier unit according to claim 10, wherein the RF signal input line (10a) and the RF signal output line (70a) are respectively implemented as RF input signal impedance matching strip line and as RF output signal impedance matching strip line for respectively transforming an input impedance and an output impedance of the RF power transistor unit (20, 200, 200a) to the RF input signal impedance and the RF output signal impedance of the RF power amplifier unit (80), the latter being preferably 50 Ω.

12. Base station (300), comprising at least one RF amplifier unit (1) according to any one of the preceding claims.

13. A communication network (400) comprising at least one RF amplifier unit (1) according to any one of the preceding claims.

14. A method for power amplification of an RF input signal (RF in), comprising:
feeding a supply voltage (Drain supply) of an unpacked envelope tracking modulator (100) to an unpackaged RF power transistor unit (20, 200, 200a), the RF power transistor unit (20, 200, 200a) and the envelope tracking modulator (100) being arranged on a common circuit board, in particular on a common RF line card (120), the supply voltage (Drain supply) depending on an envelope of the RF input signal (RF in), and
amplifying the RF input signal (RF in) in the unpackaged RF power transistor unit (20, 200, 200a).

15. Method according to claim 14, wherein the unpackaged RF power transistor unit (200, 200a) comprises at least two transistor stages (210, 211; 210a, 211a) including a driver transistor stage (210, 210a) and a final transistor stage (211, 211a), each of said transistor stages (210, 211; 210a, 211a) including a power transistor amplifier element (MOS), the output terminals (D) thereof forming a common supply voltage terminal (50), the method further comprising: feeding the supply voltage (Drain supply) to the common supply voltage terminal (50).

## Patentansprüche

1. RF-Leistungsverstärkereinheit (80) für die Hüllkurvennachführung, umfassend:
Eine RF-Leistungstransistoreinheit (20, 200, 200a) für die Verstärkung eines RF-Eingangssignals (RF in), und
einen Hüllkurvennachführungsmodulator (100) für das Einspeisen einer Versorgungsspannung (Drain-Zuführung) in Abhängigkeit von einer Hüllkurve des RF-Eingangssignals (RF in) in die RF-Leistungsstransistoreinheit (20, 200, 200a),
wobei die RF-Leistungstransistoreinheit (20, 200, 200a) und ebenfalls der Hüllkurvennachführungsmodulator (100) gehäuselos sind, und
wobei der Hüllkurvennachführungsmodulator (100) und die RF-Leistungstransistoreinheit (20, 200, 200a) auf einer gemeinsamen Leiterplatte, insbesondere einer gemeinsamen RF-Leitungskarte (120), angeordnet sind.

2. RF-Leistungsverstärkereinheit nach Anspruch 1, wobei die gehäuselose RF-Leistungstransistoreinheit (20) als ein einstufiger integrierter Leistungstransistor-Chip (21), welcher ein Leistungstransistorverstärkerelement (MOS) umfasst, implementiert wird.

3. RF-Leistungsverstärkereinheit nach Anspruch 1 oder 2, wobei die gehäuselose RF-Leistungstransistoreinheit (200; 200a) mindestens zwei Transistorstufen (210, 211; 210a, 211a), welche eine Transistorantriebsstufe (210, 210a) und eine Transistorendstufe (211, 211a) umfassen, aufweist, wobei eine jede der besagten Transistorstufen (210, 211; 210a, 211a) ein Leistungstransistorverstärkerelement (MOS) umfasst, dessen Ausgangsanschlüsse (D) vorzugsweise einen gemeinsamen Versorgungsspannungsanschluss (50) für die Versorgungsspannung (Drain-Zuführung) bilden.

4. RF-Leistungsverstärkereinheit nach Anspruch 3, wobei die mindestens zwei Transistorstufen (210a, 211a) als ein integrierter Leistungstransistorschaltungs-Chip (210a, 211a) implementiert werden.

5. RF-Leistungsverstärkereinheit nach Anspruch 3, wobei die mindestens zwei Transistorstufen jeweils als ein separater integrierter Leistungstransistorschaltungs-Chip (210, 211) implementiert werden.

6. RF-Leistungsverstäker nach einem beliebigen der Ansprüche 3 bis 5, wobei der gemeinsame Spannungsversorgungsanschluss (50) über eine gemeinsame Versorgungsspannungsleitung (50a) an den Hüllkurvennachführungsmodulator (100) angeschlossen ist.

7. RF-Leistungsverstärkereinheit nach einem beliebigen der vorstehenden Ansprüche, weiterhin umfassend: Eine RF-Signaleingangsleitung 10a) für die Bereitstellung des RF-Eingangssignals (RF in) an einen Eingangsanschluss (10) der RF-Leistungstransistoreinheit (20, 200, 200a), und eine RF-Signalausgangsleitung (70a) für den Empfang eines verstärkten RF-Ausgangssignals (RF out) von einem Ausgangsanschluss (70) der besagten RF-Leistungstransistoreinheit (20, 200, 200a).

8. RF-Leistungsverstärkereinheit nach Anspruch 7, wobei die RF-Signalausgangsleitung (70a) einen Spannungsversorgungsanschluss (50) einer Versorgungsspannungsleitung (50a), welche die RF-Leistungstransistoreinheit (20) mit dem Hüllkurvennachführungsmodulator (100) verbindet, umfasst.

9. RF-Leistungsverstärkereinheit nach Anspruch 7 oder 8, wobei die RF-Signaleingangsleitung (10a) einen Verstärkervorspannungsanschluss (40) einer Verstärkervorspannungsleitung (40a) für die Bereitstellung einer Verstärkervorspannung (Gate-Zuführung) an die RF-Leistungstransistoreinheit (20) umfasst.

10. RF-Leistungsverstärkereinheit nach einem beliebigen der Ansprüche 7 bis 9, wobei die RF-Leitungskarte (120) als eine RF-Streifenleitungskarte, auf welcher die RF-Signaleingangsleitung (10a) und die RF-Signalausgangsleitung (70a) jeweils als RF-Streifenleitungen angeordnet und vorzugsweise über jeweilige Bonddrähte (60, 60a) an den RF-Signaleingangsanschluss (10) und an den RF-Signalausgangsanschluss (70) der RF-Leistungstransistoreinheit (20, 200, 200a) angeschlossen ist, implementiert wird.

11. RF-Leistungsverstärkereinheit nach Anspruch 10, wobei die RF-Signaleingangsleitung (10a) und die RF-Signalausgangsleitung (70a) als eine RF-Eingangssignalimpedanzanpassungsstreifenleitung beziehungsweise als eine RF-Ausgangssignalimpedanzanpassungsstreifenleitung implementiert werden, um eine Eingangsimpedanz beziehungsweise eine Ausgangsimpedanz der RF-Leistungstransistoreinheit (20, 200, 200a) in die RF-Eingangssignalimpedanz beziehungsweise die RF Ausgangssignalimpedanz der RF-Leistungsverstärkereinheit (80) umzuwandeln, wobei letztere vorzugsweise 50 Ω beträgt.

12. Basisstation (300), umfassend mindestens eine RF-Verstärkereinheit (1) gemäß einem der vorstehenden Ansprüche.

13. Kommunikationsnetzwerk (400), umfassend mindestens eine RF-Verstärkereinheit (1) gemäß einem der vorstehenden Ansprüche.

14. Verfahren für die Leistungsverstärkung eines RF-Eingangssignals (RF in), umfassend:
Einspeisen einer Versorgungsspannung (Drain-Zuführung) eines gehäuselosen Hüllkurvennachführungsmodulators (100) in eine gehäuselose RF-Leistungstransistoreinheit (20, 200, 200a), wobei die RF-Leistungstransistoreinheit (20, 200, 200a) und der Hüllkurvennachführungsmodulator (100) auf einer gemeinsamen Leiterplatte, insbesondere auf einer gemeinsamen RF-Leitungskarte (120) angeordnet sind, wobei die Leistungsspannung (Drain-Zuführung) von einer Hüllkurve des RF-Eingangssignals (RF in) abhängt, und
Verstärken des RF-Eingangssignals (RF in) in der gehäuselosen RF-Leistungstransistoreinheit (20.200,200a).

15. Verfahren nach Anspruch 14, wobei die gehäuselose RF-Leistungstransistoreinheit (200, 200a) mindestens zwei Transistorstufen (210, 211; 210a, 211a) einschließlich einer Transistorantriebsstufe (210, 210a) und einer Transistorendstufe (211, 211a) umfasst, wobei eine jede der besagten Transistorstufen (210, 211; 210a, 211a) ein Leistungstransistorverstärkerelement (MOS) umfasst, dessen Ausgangsanschlüsse (D) einen gemeinsamen Versorgungsspannungsanschluss (50) bilden, wobei das Verfahren weiterhin umfasst: Einspeisen der Versorgungsspannung (Drain-Zuführung) in den gemeinsamen Versorgungsspannungsanschluss (50).

## Revendications

1. Unité amplificateur de puissance RF (80) pour le suivi d'enveloppe,
comprenant :
une unité à transistor de puissance RF (20, 200, 200a) pour l'amplification d'un signal d'entrée RF (RF in), et
un modulateur de suivi d'enveloppe (100) pour acheminer une tension d'alimentation (alimentation du drain) en fonction d'une enveloppe du signal d'entrée RF (RF in) à l'unité à transistor de puissance RF (20, 200, 200a),
l'unité à transistor de puissance RF (20, 200, 200a) ainsi que le modulateur de suivi d'enveloppe (100) n'étant pas en boîtier, et
le modulateur de suivi d'enveloppe (100) et l'unité à transistor de puissance RF (20, 200, 200a) étant disposés sur un circuit imprimé commun, notamment sur une carte de ligne RF commune (120).

2. Unité amplificateur de puissance RF selon la revendication 1, avec laquelle l'unité de transistor de puissance RF (20) sans boîtier est mise en oeuvre sous la forme d'une puce de transistor de puissance intégrée à un étage (21) qui comprend un élément amplificateur à transistor de puissance (MOS).

3. Unité amplificateur de puissance RF selon la revendication 1 ou 2, avec laquelle l'unité de transistor de puissance RF (200 ; 200a) sans boîtier comprend au moins deux étages à transistor (210, 211 ; 210a, 211a) comprenant un étage à transistor d'excitation (210, 210a) et un étage à transistor final (211, 211a), chacun desdits étages à transistor (210, 211 ; 210a, 211a) comprenant un élément amplificateur à transistor de puissance (MOS) dont les bornes de sortie (D) forment de préférence une borne de tension d'alimentation commune (50) pour la tension d'alimentation (alimentation du drain).

4. Unité amplificateur de puissance RF selon la revendication 3, avec laquelle les au moins deux étages à transistor (210a, 211a) sont mis en oeuvre sous la forme d'une puce de circuit de transistor de puissance intégrée (210a, 211a).

5. Unité amplificateur de puissance RF selon la revendication 3, avec laquelle les au moins deux étages à transistor sont respectivement mis en oeuvre sous la forme d'une puce de circuit de transistor de puissance intégrée séparée (210, 211).

6. Unité amplificateur de puissance RF selon l'une quelconque des revendications 3 à 5, avec laquelle la borne de tension d'alimentation commune (50) est connectée au modulateur de suivi d'enveloppe (100) par le biais d'une ligne de tension commune (50a).

7. Unité amplificateur de puissance RF selon l'une quelconque des revendications précédentes, comprenant en outre une ligne d'entrée de signal RF (10a) pour délivrer le signal d'entrée RF (RF in) à une borne d'entrée (10) de l'unité à transistor de puissance RF (20, 200, 200a),
et une ligne de sortie de signal RF (70a) pour recevoir de la part d'une borne de sortie (70) de ladite unité à transistor de puissance RF (20, 200, 200a) un signal de sortie RF amplifié (RF out).

8. Unité amplificateur de puissance RF selon la revendication 7, avec laquelle la ligne de sortie de signal RF (70a) comprend une borne de tension d'alimentation (50) d'une ligne de tension d'alimentation (50a) qui connecte l'unité à transistor de puissance RF (20) au modulateur de suivi d'enveloppe (100).

9. Unité amplificateur de puissance RF selon la revendication 7 ou 8, avec laquelle la ligne d'entrée de signal RF (10a) comprend une borne de polarisation d'amplificateur (40) d'une ligne de polarisation d'amplificateur (40a) pour délivrer une tension de polarisation d'amplificateur (alimentation de la gâchette) à l'unité à transistor de puissance RF (20).

10. Unité amplificateur de puissance RF selon l'une quelconque des revendications 7 à 9, avec laquelle la carte de ligne RF (120) est mise en oeuvre sous la forme d'une carte à ligne à ruban RF sur laquelle la ligne d'entrée du signal RF (10a) et la ligne de sortie du signal RF (70a) sont respectivement disposées sous la forme de lignes à ruban RF connectées à la borne d'entrée de signal RF (10) et à la borne de sortie de signal RF (70) de l'unité à transistor de puissance RF (20, 200, 200a), de préférence par le biais de fils de liaison respectifs (60, 60a).

11. Unité amplificateur de puissance RF selon la revendication 10, avec laquelle la ligne d'entrée de signal RF (10a) et la ligne de sortie de signal RF (70a) sont respectivement mises en oeuvre sous la forme d'une ligne à ruban à adaptation d'impédance du signal d'entrée RF et sous la forme d'une ligne à ruban à adaptation d'impédance du signal de sortie RF pour transformer respectivement une impédance d'entrée et une impédance de sortie de l'unité à transistor de puissance RF (20, 200, 200a) en l'impédance du signal d'entrée RF et en l'impédance du signal de sortie RF de l'unité amplificateur de puissance RF (80), cette dernière étant de préférence de 50 Ω.

12. Station de base (300), comprenant au moins une unité amplificateur RF (1) selon l'une quelconque des revendications précédentes.

13. Réseau de communication (400) comprenant au moins une unité amplificateur RF (1) selon l'une quelconque des revendications précédentes.

14. Procédé d'amplification de puissance d'un signal d'entrée RF (RF in), comprenant :
Acheminement d'une tension d'alimentation (alimentation du drain) d'un modulateur de suivi d'enveloppe (100) sans boîtier à une unité à transistor de puissance RF (20, 200,
200a) sans boîtier, l'unité à transistor de puissance RF (20, 200, 200a) et le modulateur de suivi d'enveloppe (100) étant disposés sur un circuit imprimé commun, notamment sur une carte de ligne RF commune (120), la tension d'alimentation (alimentation du drain) dépendant d'une enveloppe du signal d'entrée RF (RF in), et
Amplification du signal d'entrée RF (RF in) dans l'unité à transistor de puissance RF (20, 200, 200a) sans boîtier.

15. Procédé selon la revendication 14, dans lequel l'unité de transistor de puissance RF (200 ; 200a) sans boîtier comprend au moins deux étages à transistor (210, 211 ; 210a, 211a) comprenant un étage à transistor d'excitation (210, 210a) et un étage à transistor final (211, 211a), chacun desdits étages à transistor (210, 211 ; 210a, 211a) comprenant un élément amplificateur à transistor de puissance (MOS) dont les bornes de sortie (D) forment une borne de tension d'alimentation commune (50), le procédé comprenant en outre : acheminement de la tension d'alimentation (alimentation du drain) à la borne de tension d'alimentation commune (50).
